(19) Europäisches Patentamt
European Patent Office
Office européen des brevets

(11) Numéro de publication: **0 246 146 B1**

(12) # FASCICULE DE BREVET EUROPEEN

(45) Date de publication de fascicule du brevet: **23.06.93** (51) Int. Cl.$^5$: **G01R 33/26**

(21) Numéro de dépôt: **87401054.9**

(22) Date de dépôt: **07.05.87**

(54) **Magnétomètre à hélium pompé par laser.**

(30) Priorité: **12.05.86 FR 8606776**

(43) Date de publication de la demande:
**19.11.87 Bulletin 87/47**

(45) Mention de la délivrance du brevet:
**23.06.93 Bulletin 93/25**

(84) Etats contractants désignés:
**AT BE CH DE ES FR GB GR IT LI LU NL SE**

(56) Documents cités:
**DE-A- 3 150 391**
**FR-A- 1 352 700**
**US-A- 3 629 697**
**US-A- 4 193 029**
**US-A- 4 327 327**

**REVIEW OF SCIENTIFIC INSTRUMENTS, vol. 53, no. 9, septembre 1982, pages 1434-1437, American Institute of Physics, New York, US; C. CHENG et al.: "Measurement of the spin polarization of an optically pumped ensemble of He (23S) atoms"**

**IEEE JOURNAL OF OUANTUM ELECTRONICS, vol. OE-22, no. 5, mai 1986, pages 713-716, IEEE, New York, US; L.D. SCHEARER et al.: "LNA: a new CW Nd laser tunable around 1.05 and 1.08 mum"**

**IEEE TRANSACTIONS ON MAGNETICS, vol. Mag 8, no. 1, mars 1972, pages 66-75, IEEE, New York, US; F. HARTMANN: "Resonance magnetometers"**

(73) Titulaire: **CENTRE NATIONAL DE LA RECHERCHE SCIENTIFIOUE (CNRS)**
**15, Ouai Anatole France**
**F-75700 Paris Cedex 07(FR)**

(72) Inventeur: **Leduc, Michèle**
**27, rue Simon**
**F-94480 Ablon Sur Seine(FR)**
Inventeur: **Schearer, Laird**
**207 Lover Lane**
**Rolla Missouri 65401(US)**
Inventeur: **Laloe, Franck**
**62, Boulevard Arago**
**F-75013 Paris(FR)**
Inventeur: **Hamel, Joseph**
**38, rue des Coteaux**
**F-14760 Bretteville sur Odon(FR)**

(74) Mandataire: **Plaçais, Jean-Yves et al**
**Cabinet Netter, 40, rue Vignon**
**F-75009 Paris (FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).



Rank Xerox (UK) Business Services
(3.10/3.6/3.3.1)

## Description

L'invention concerne les magnétomètres, c'est-à-dire les appareils permettant la mesure de l'induction magnétique.

On connaît déjà des magnétomètres à hélium. Ils comportent :

- une cellule sensible, formée d'une enceinte au moins en partie transparente, contenant de l'hélium,
- une source de lumière d'excitation, dirigée vers la cellule sensible,
- des moyens pour créer dans l'hélium une population d'atomes métastables,
- l'induction magnétique régnant dans la cellule étant mesurable d'après des caractéristiques de résonance magnétique d'un niveau énergétique de l'hélium. Pour que se produise la résonance magnétique, il est en principe nécessaire de créer dans l'hélium une population d'atomes métastables, ce qui peut se faire à l'aide d'une décharge électrique dite "douce", sur laquelle on reviendra plus loin.

Les magnétomètres à hélium sont des appareils très performants.

L'un des buts de la présente invention est d'en améliorer encore les performances, de façon à permettre la mesure absolue et précise de très faibles inductions magnétiques, ou de très petites variations de cette induction.

Un autre but de l'invention est d'améliorer considérablement, de plusieurs ordres de grandeur, la qualité du signal détecté, pour la mesure de l'induction magnétique.

Un autre but de l'invention est de permettre la réalisation d'un magnétomètre où les rayonnements optiques puissent être transmis à l'aide de fibres optiques.

En conséquence, un autre but encore de l'invention est de permettre la réalisation de sondes magnétométriques miniaturisées et extrêmement maniables.

L'invention a encore pour but de fournir un magnétomètre qui présente une consommation énergétique moyenne très faible.

Dans sa définition la plus générale, l'invention réside en ce que la source de la lumière d'excitation est agencée en laser accordable à bande étroite, et comprend un laser à semi-conducteur (réseau de diodes).

Le rayonnement issu de ce laser peut être focalisé vers le laser accordable lui-même.

Selon un autre aspect de l'invention, la source de lumière d'excitation comprend un laser du type LNA (aluminate de lanthane-néodyme).

Selon un autre aspect de l'invention, la lumière du laser est amenée à la cellule sensible à travers une fibre optique.

Un autre avantage des lasers LNA réside en ce qu'ils peuvent fournir directement une lumière polarisée linéairement, qui pourrait être appliquée directement à la cellule sensible.

De préférence, la lumière linéairement polarisée, issue du laser LNA, est transformée en lumière circulairement polarisée avant d'être transmise à la cellule sensible.

Fonctionnellement, on associe à la cellule sensible des moyens capables d'y produire une décharge électrique douce à haute fréquence, afin que soient créés des atomes d'hélium métastables. Le laser accordable à bande étroite est accordé sur une raie d'une transition spectrale partant de cet état métastable.

Comme on le verra plus loin, la décharge électrique douce est une décharge qui suffit à produire un début de rayonnement lumineux dans la cellule sensible, sans toutefois atteindre le fonctionnement radiatif intense d'une "lampe à hélium". Il s'agit de peupler des niveaux métastables de l'hélium, sans réduire trop notablement leurs temps de relaxation, qui doivent rester de l'ordre de la milliseconde.

Plus particulièrement, les atomes d'hélium métastables intéressants sont ceux du niveau $2^3S_1$; la transition spectrale est une transition $2^3P$-$2^3S_1$, par exemple la transition $2^3P_1$-$2^3S_1$ pour certaines applications.

Selon un premier mode de réalisation de l'invention, le magnétomètre comporte des moyens pour mesurer l'induction magnétique à partir de la fréquence de résonance magnétique électronique de l'hélium dans le niveau métastable choisi.

Ce premier mode de réalisation s'applique principalement à l'hélium naturel ($^4He$), mais il pourrait également s'appliquer à l'hélium isotopique ($^3He$).

Plus précisément, les moyens de mesure comprennent alors :

- des moyens pour appliquer à la cellule sensible un champ électromagnétique de radiofréquence variable, transversal à la direction de la lumière d'excitation, et
- des moyens pour déterminer la valeur de la radiofréquence pour laquelle se produit la résonance magnétique électronique des atomes métastables, $2^3S_1$, à partir d'une détection du flux lumineux transmis à travers la cellule sensible.

Avantageusement, le flux lumineux transmis est véhiculé par une seconde fibre optique.

Dans un second mode de réalisation de l'invention, la cellule sensible contient de l'hélium isotopique $^3He$, la mesure de l'induction magnétique s'effectue alors à partir de la fréquence de résonance magnétique nucléaire des atomes de $^3He$, en leur état fondamental.

Dans ce cas, les moyens de mesure comprennent plus particulièrement :

- une première paire de bobines alimentées temporairement en signal électrique radiofréquence, de manière à provoquer un basculement bref de l'orientation nucléaire longitudinale des atomes $^3$He, et
- une seconde paire de bobines, montées au voisinage immédiat de la cellule sensible, pour capter la force électromotrice induite par la précession libre des spins nucléaires des atomes $^3$He, après leur basculement forcé. La fréquence du signal ainsi capté est directement proportionnelle à la valeur de l'induction magnétique régnant dans la cellule sensible. Cette mesure est effectuée "dans le noir" : décharge et laser de pompage éteints. Elle peut durer plusieurs heures.

D'autres caractéristiques et avantages de l'invention apparaîtront à l'examen de la description détaillée ci-après, et des dessins annexés, sur lesquels :

- la figure 1 est un schéma de principe du premier mode de réalisation de l'invention;
- la figure 2 est un schéma de principe d'un laser LNA utilisable pour la mise en oeuvre de l'invention;
- la figure 3 est un schéma plus détaillé du premier mode de réalisation de l'invention;
- la figure 4 est un schéma de principe du second mode de réalisation de l'invention;
- la figure 5 est un schéma plus détaillé du second mode de réalisation de l'invention; et
- la figure 6 est un diagramme d'état atomique permettant de mieux comprendre le fonctionnement de l'invention, en son second mode de réalisation.

Les dessins serviront à mieux faire comprendre la description détaillée ci-après. Ils pourront également contribuer à la définition de l'invention, le cas échéant.

Sur les figures 1, 3, 4 et 5, on a représenté en 1 la sonde magnétométrique proprement dite. Elle est constituée par exemple d'une cellule sphérique en pyrex, de trois centimètres de diamètre, remplie d'hélium très pur sous une pression de 1 Torr. Dans le premier mode de réalisation, qui fait l'objet des figures 1 et 3, il s'agit de préférence d'hélium $^4$He, mais l'hélium $^3$He pourrait aussi être utilisé pour certaines applications.

Par contre, le second mode de réalisation, qui fait l'objet des figures 4 et 5, utilise nécessairement l'hélium isotopique $^3$He.

Un oscillateur 3 crée une décharge douce, c'est-à-dire une très faible décharge dans la cellule, de manière à y créer une population d'atomes métastables dont le niveau d'énergie est $2^3S_1$, ou plus simplement $2^3S$ selon la notation de Mulliken.

Comme le montrent les figures 3 et 5, la cellule est à cet effet encadrée de deux plaques annulaires 31 et 32, reliées à l'enroulement secondaire d'un transformateur 33, accordé sur une fréquence de l'ordre du Mégahertz. L'enroulement primaire du transformateur est bouclé sur un amplificateur à large bande d'une puissance maximale d'environ 3 watts.

Il se produit alors un accrochage spontané du système, à une fréquence voisine de 1 Mégahertz. Et cet accrochage s'accompagne de la production dans la cellule de la très faible décharge désirée, avec création des atomes métastables $2^3S$.

Les spécialistes de la spectroscopie de l'hélium parlent alors de décharges douces. Le courant de la décharge électrique haute fréquence est juste suffisant pour se situer au seuil d'allumage de la sonde en "lampe à hélium"; toutefois, l'énergie apportée à la cellule pour cela n'est pas très importante, c'est-à-dire que cette "lampe" éclaire peu; il en résulte que sont créés des atomes métastables du niveau voulu $2^3S$, (entre autres), et que ceux-ci sont peu perturbées par la décharge douce (telle que définie plus haut).

Un laser à LNA, qui est un laser accordable à bande étroite, fournit un faisceau lumineux de pompage à la cellule 1. La direction de ce faisceau dans la cellule est illustrée par la flèche D (figures 1 et 4). L'appareil donne une mesure de l'induction magnétique, qui est indépendante de l'orientation. Toutefois la précision de la mesure dépend de l'orientation de l'induction par rapport à D.

La lumière provenant du laser possède une longueur d'onde de 1,08 micromètre. Elle sort du laser avec une polarisation linéaire. Elle est transmise, directement, ou par une fibre optique 28, à un organe de polarisation circulaire 29 (simple lame quart d'onde, en transmission directe, ou bien polariseur linéaire + lame quart d'onde, après la fibre optique). Les atomes métastables d'hélium créés par la décharge sont ainsi orientés longitudinalement, selon la direction D.

Il est maintenant fait référence à la figure 2, qui illustre un mode de réalisation d'un laser LNA utilisable selon l'invention. Un laser LNA a été notamment décrit dans l'article "LNA : a new CW Nd laser tunable around 1.05 and 1.08 nm," de L.D. Schearer, M. Leduc, B. Vivien, A.M. Lejus et J. Théry, I.E.E.E. Journal of Quantum Electronics, Volume QE22, page 713, Mai 1986.

Le milieu amplificateur 20 du laser 2 est ici un monocristal d'aluminate de lanthane-néodyme ou LNA. Il est situé dans une cavité à deux miroirs 21 et 22. Le cristal est pompé longitudinalement, par exemple à travers le miroir 21, par un rayonnement qui peut provenir d'un autre laser, de préférence selon l'invention un réseau de diodes laser à semi-conducteurs, propres à émettre un rayonnement de 200 milliwatts à 800 nanomètres. Un tel réseau, illustré en 23, est par exemple le modèle SDL 2420 de Spectra Diode Labs (Etats-Unis).

Le miroir 21 peut être une couche multidiélectrique déposée directement sur le cristal de LNA.

Un organe optique 24 permet de collimater ce faisceau et de le focaliser pour qu'il frappe le monocristal 20.

La cavité du laser LNA comprend encore un organe d'accord 25, qui peut être de différentes natures. On utilise par exemple un filtre de Lyot, qui permet un accord autour de 1,08 micromètre. La largeur de bande de la lumière de sortie du laser est dans ce cas environ 6 nanomètres.

Très avantageusement un étalon E, mince, non revêtu, est inséré dans la cavité pour fournir un accord beaucoup plus fin, en même temps qu'une réduction significative de la largeur de bande.

Ce laser fournit donc une lumière à 1,08 micromètre, pour une bande très étroite, avec une possibilité d'accord limité.

On ne considère maintenant que le premier mode de réalisation de l'invention.

Le laser LNA 2 (figures 1 et 3) est accordé sur l'une des transitions $2^3P$-$2^3S$ du spectre de l'hélium naturel $^4He$.

Cet accord peut être réalisé sur la transition de structure fine D1, qui correspond aux échanges $2^3P_1$-$2^3S$, ou bien sur la transition D0 ($2^3P_0$-$2^3S$) voire sur la transition D2 ($2^3P_2$-$2^3S$). On appelle "structure fine" la structure énergétique provenant du couplage entre le moment cinétique orbital et le spin de l'électron.

L'important est en tous cas que le laser ne soit accordé que sur l'une des transitions intéressantes du spectre de l'hélium.

En effet, il s'ensuit alors une modification considérable du fonctionnement du magnétomètre, dont les signaux observés sont alors beaucoup plus intenses.

Il semble que la raison en soit la suivante : lorsque, selon la technique antérieure, on utilise pour l'excitation du magnétomètre une lampe à hélium, celle-ci émet simultanément les trois raies D0,D1 et D2 de la transition ($2^3P$-$2^3S$ ). Leur trop faible différence de longueur d'onde ne permet pas de les isoler, pour n'appliquer qu'une seule de ces transitions à la cellule de mesure 1. Les trois raies sont donc excitées dans la cellule de mesure. Mais il a été observé que les contributions simultanées de ces trois raies s'opposent, et diminuent par là considérablement la réponse du magnétomètre au phénomène observé, c'est-à-dire sa réponse à l'induction magnétique.

Au contraire, avec l'excitation laser selon la présente invention,on peut exciter une seule des trois raies de la transition, en l'espèce de préférence la raie D1 ou D0. La réponse du magnétomètre est alors considérablement améliorée.

La mesure proprement dite de l'induction magnétique peut se faire de la manière suivante :

- un champ de radiofréquence, perpendiculaire à la direction D de l'induction B, est créé par deux spires 41 et 42, de quatre centimètres de diamètre, disposées en position d'Helmholtz de part et d'autre de la cellule 1. Ces bobines sont alimentées par un générateur radiofréquence 40, dont on peut moduler la fréquence autour d'une valeur ajustable.

Le champ de radiofréquence ainsi créé perpendiculairement à l'induction magnétique B induit la résonance magnétique électronique de l'hélium à partir du niveau $2^3S$.

- L'observation de la résonance peut se faire notamment à partir du rayonnement transmis par la cellule 1. Ce rayonnement transmis, noté FT, est appliqué directement ou par une fibre optique 43 (figure 3) à un photodétecteur 44.

Il a été observé que la longueur d'onde du rayonnement concerné se situe aux limites de l'efficacité des photodiodes au silicium mais par contre est correctement analysée par la plupart des diodes au germanium. Toutefois, des mesures récentes ont montré que les photodiodes au silicium modèle S1336-8BQ de la Société Hamamatsu (Japon) étaient sensibles au rayonnement à 1,08 micromètre, avec un excellent rapport signal/bruit.

Le courant photoélectrique de la diode peut être analysé directement. Pour plus de précision, on peut aussi effectuer une détection synchrone en 45, avec pour signal local la sortie du générateur 40. La mesure se termine alors avec la détermination de la fréquence de résonance magnétique électronique, par l'étage 46. Cette mesure est effectuée sur une détection de zéro, c'est-à-dire lorsque l'étage de détection synchrone 45 indique que le faisceau transmis est en quadrature. Il suffit alors de mesurer la fréquence appliquée par le générateur 40.

Il a été observé que le générateur 40 peut avoir une puissance de quelques milliwatts seulement, qui suffit pour saturer la résonance magnétique électronique. La fréquence N de celle-ci est reliée à l'induction magnétique B par la relation :

$$N = 28 B,$$

où N est exprimé en Mégahertz, et B en millitesla.

L'homme de l'art comprendra que l'appareil selon l'invention est destiné à des mesures précises. En règle générale, avant de mettre en oeuvre cet appareil, on dispose déjà d'informations moins précises ("grossières") sur l'induction magnétique à mesurer. A partir de là, il n'est pas difficile de déterminer la fréquence du générateur 40 autour de laquelle on va devoir opérer pour mesurer précisément l'induction magnétique, ou ses petites variations.

En effet, les applications d'un magnétomètre aussi précis que celui de l'invention sont par exemple la mesure de petites variations des composantes du champ magnétique terrestre, à des fins de détection diverses de matériaux métalliques ou de champs pétrolifères, par exemple.

Le premier mode de réalisation de l'invention a été décrit jusqu'à présent en référence à l'hélium $^4$He. Comme précédemment indiqué, il pourrait aussi s'appliquer à l'hélium $^3$He, pour l'une ou l'autre des transitions que celui-ci présente à partir de l'état $2^3$S.

Cependant, l'invention offre aussi un second mode de réalisation, différent, applicable au seul $^3$He, et qui présente l'avantage d'une très faible consommation électrique.

La cellule de mesure 1 est la même que précédemment, sous réserve qu'elle est maintenant remplie d'hélium isotopique $^3$He sous une pression de 1 Torr. Le dispositif de décharge douce reste également inchangé.

Il en est de même pour le pompage optique de la cellule 1 par le laser 2, qui s'effectue à une longueur d'onde d'environ 1,08 micromètre.

Il est maintenant fait référence à la figure 6, qui illustre différents états de l'hélium isotopique $^3$He.

La cellule remplie de $^3$He est donc soumise à la décharge haute fréquence. Les atomes métastables $^3$He ($2^3S_1$), créés par la décharge, sont orientés par le pompage optique dans la direction D (orientation électronique).

La différence entre l'hélium $^4$He et l'hélium $^3$He réside en ce que ce dernier possède un spin nucléaire.

Par "couplage hyperfin", les atomes $^3$He acquièrent une orientation nucléaire longitudinale (direction D), dans l'état métastable $2^3S_1$.

Ce "couplage hyperfin" intervient entre le moment cinétique électronique total et le spin nucléaire de $^3$He dans l'état $2^3S_1$.

Par ailleurs, il se produit des collisions d'échange de métastabilité entre les atomes de l'état excité $2^3S_1$, et ceux de l'état fondamental $1^1S_0$. Ces collisions transfèrent l'orientation nucléaire, qui passe donc des atomes métastables excités vers ceux de l'état fondamental de $^3$He.

Le résultat de ce processus est qu'on obtient un gaz d'atome isotopique $^3$He, à l'état fondamental, dont les noyaux sont orientés dans la direction de l'induction magnétique à mesurer. Au terme du processus complexe qui vient d'être brièvement décrit, il apparait que les atomes d'hélium dans l'état fondamental ont acquis une polarisation nucléaire longitudinale.

Un dispositif de séquencement 70 (figure 5) peut alors arrêter le fonctionnement du laser 2 et de l'oscillateur de décharge douce 3, par exemple en inhibant l'amplificateur 34 que comprend celui-ci.

Le gaz d'atomes ainsi orienté dans la cellule peut alors demeurer sensible au champ magnétique pendant un temps considérable, qui peut être supérieur à une journée.

La mesure de l'induction magnétique proprement dite peut se faire par une résonance magnétique nucléaire de ces atomes.

Pour cela, on dispose d'une paire de bobines de petite taille 51 et 52 (illustrées en tireté sur la figure 5) placées de part et d'autre de la cellule 1. On notera au passage que ces bobines doivent seulement être d'axe perpendiculaire à la direction D suivant laquelle on mesure l'induction B. Ainsi, les bobines 51 et 52 pourraient tout aussi bien être parallèles aux bobines 61 et 62 dont il sera question plus loin.

Un générateur radiofréquence 50 est excité brièvement de manière à fournir une radiofréquence wobulée, suivant une pente choisie, de manière qu'on soit certain de passer par la fréquence de résonance magnétique pendant une durée adaptée. Le générateur 50 est ensuite arrêté.

Au passage à la bonne fréquence, il se sera produit un basculement bref de l'orientation longitudinale des spins nucléaires du $^3$He. En d'autres termes, alors qu'ils étaient initialement dans la direction de l'induction B, ces spins vont se trouver prendre une direction perpendiculaire.

Les spécialistes savent qu'après un tel basculement, il va se produire une précession libre des spins nucléaires, autour de la direction du champ statique, à une fréquence proportionnelle à l'amplitude de l'induction B dans la cellule.

On prévoit donc deux autres bobines 61 et 62, placées avantageusement en position d'Helmholtz de part et d'autre de la cellule 1, avec un axe commun perpendiculaire à la direction de mesure de l'induction B.

Le signal recueilli aux bornes des bobines 61 et 62 est appliqué à un dispositif de traitement de signal 71, qui va par exemple en écarter le bruit. Il suffit ensuite de procéder à une mesure de fréquence en l'étage 72, de l'une des manières connues en résonance magnétique nucléaire.

En d'autres termes, la paire de bobines 61 et 62 capte la force électromotrice induite par la précession libre des spins nucléaires après leur basculement forcé. Et il suffit de mesurer la fréquence de ce signal pour retrouver la valeur de l'induction magnétique, par la relation suivante:

$$N = 32{,}44\ B,$$

où N est la fréquence mesurée, exprimée en kilohertz, tandis que B est l'induction magnétique, exprimée en millitesla.

La fréquence du signal recueilli aux bornes des bobines est donc directement proportionnelle à la valeur de l'induction magnétique à mesurer.

En plus des avantages qu'il possède en commun avec le premier mode de réalisation, ce dispositif s'accommode aussi d'une consommation énergétique moyenne très faible.

Il suffit en effet de procéder à une excitation de la cellule par la décharge électrique douce, et l'allumage du laser à LNA 2. Ensuite, pendant quelques minutes, on crée l'orientation nucléaire de l'hélium $^3He$.

On peut alors arrêter toute excitation électrique. On provoque le basculement bref des spins nucléaires dans l'état fondamental. Intervient ensuite la précession libre des moments magnétiques nucléaires dans l'induction magnétique à mesurer, phase qui peut durer plusieurs heures.

## Revendications

**1.** Magnétomètre à hélium, du type comprenant :
- une cellule sensible (1), formée d'une enceinte, au moins en partie transparente, contenant de l'hélium,
- une source de lumière d'excitation (2), dirigée vers la cellule sensible,
- des moyens (3) pour créer dans l'Hélium une population d'atomes métastables,
- l'induction magnétique régnant dans la cellule étant mesurable d'après des caractéristiques de résonance magnétique d'un niveau énergétique de l'hélium,

caractérisé en ce que la source de lumière d'excitation (2) est un laser accordable à bande étroite, propre à exciter sélectivement sensiblement une et une seule des transitions à partir d'un état métastable de l'hélium, et comprend un laser (23) à semi-conducteur.

**2.** Magnétomètre selon la revendication 1, caractérisé en ce que la source de lumière d'excitation (2) comprend un laser du type LNA (aluminate de lanthane-néodyme).

**3.** Magnétomètre selon la revendication 2, caractérisé en ce que ledit laser LNA (2) comprend :
- un monocristal (20) de LNA placé entre deux organes réfléchissants (21, 23),
- des moyens de pompage primaire (23, 24) de ce laser, et
- des moyens d'accord (25) de ce laser.

**4.** Magnétomètre selon l'une des revendications 2 et 3, caractérisé en ce que la lumière de sortie (FP) du laser LNA est transmise à la cellule sensible à travers un polariseur circulaire (29).

**5.** Magnétomètre selon l'une des revendications 1 à 4, caractérisé en ce que la lumière du laser (FP) est amenée à la cellule sensible à travers une fibre optique (28).

**6.** Magnétomètre selon l'une des revendications 1 à 6, caractérisé en ce qu'il comprend des moyens (3) associés à la cellule sensible, pour y produire une décharge électrique douce à haute fréquence, propre à créer des atomes d'hélium métastables, et en ce que le laser accordable à bande étroite (2) est accordé sur une raie d'une transition spectrale à partir de cet état métastable.

**7.** Magnétomètre selon la revendication 6, caractérisé en ce que les atomes d'hélium métastable sont ceux du niveau $2^3S$ et en ce que la transition spectrale est une transition $2^3P$-$2^3S$.

**8.** Magnétomètre selon l'une des revendications 1 à 7, caractérisé en ce qu'il comporte des moyens pour mesurer l'induction magnétique à partir de la fréquence de résonance magnétique électronique de l'hélium dans le niveau métastable.

**9.** Magnétomètre selon la revendication 8, caractérisé en ce que les moyens de mesure comprennent :
- des moyens (40, 41, 42) pour appliquer à la cellule sensible un champ électromagnétique de radiofréquence variable, transversal à la direction de la lumière d'excitation, et
- des moyens (44, 45, 46) pour déterminer la valeur de la radiofréquence pour laquelle se produit la résonance magnétique électronique des atomes métastables $2^3S_1$, à partir d'une détection (44) du flux lumineux transmis à travers la cellule sensible.

**10.** Magnétomètre selon la revendication 9, caractérisé en ce que les moyens de mesure du flux lumineux transmis opèrent avec détection synchrone (45), par rapport à la valeur de la fréquence du champ électromagnétique transversal.

**11.** Magnétomètre selon l'une des revendications 9 et 10, caractérisé en ce que la mesure du flux lumineux transmis (FT) est réalisée à l'aide d'une autre fibre optique (43).

**12.** Magnétomètre selon l'une des revendications 8 à 11, caractérisé en ce que la cellule sensible (1) contient de l'hélium naturel $^4He$.

**13.** Magnétomètre selon l'une des revendications 1 à 7, caractérisé en ce que la cellule sensible (1) contient de l'hélium isotopique $^3He$, et en ce qu'il comprend des moyens (7) pour mesurer l'induction magnétique à partir de la fréquence de résonance magnétique nucléaire des atomes de $^3He$.

**14.** Magnétomètre selon la revendication 13, caractérisé en ce que les moyens de mesure comprennent :
- une première paire de bobines (50), alimentées temporairement pour provoquer un basculement bref de l'orientation nucléaire longitudinale des atomes de $^3He$, et
- une seconde paire de bobines (61, 62), montées au voisinage immédiat de la cellule sensible, pour capter la force électromotrice induite par la précession libre des spins nucléaires des atomes de $^3He$, après leur basculement forcé, la fréquence du signal ainsi capté (71, 72) étant directement proportionnelle à la valeur de l'induction magnétique régnant dans la cellule sensible.

## Claims

**1.** Helium magnetometer, of the type comprising
- a sensitive cell (1) formed by an enclosure which is at least partly transparent and contains helium,
- an excitational-light source (2) directed towards the sensitive cell,
- means (3) for creating a population of metastable atoms in the helium,
- the magnetic induction existing in the cell being measurable from magnetic resonance characteristics of a helium energy level,

characterised in that the excitational-light source (2) is a narrow-band tunable laser capable of exciting selectively substantially one and only one of the transitions from a helium metastable state, and comprises a semiconductor laser (23) as the primary pumping means.

**2.** Magnetometer according to Claim 1, characterised in that the excitational-light source (2) comprises a laser of the LNA (lanthanum-neodymium aluminate) type.

**3.** Magnetometer according to Claim 2, characterised in that the said LNA laser (2) comprises:
- a single crystal (20) of LNA placed between two reflecting elements (21, 23),
- primary pumping means (23, 24) for this laser, and
- means (25) for tuning this laser.

**4.** Magnetometer according to either of Claims 2 and 3, characterised in that the output light (FP) of the LNA laser is transmitted to the sensitive cell through a circular polariser (29).

**5.** Magnetometer according to one of Claims 1 to 4, characterised in that the light from the laser (FP) is conveyed to the sensitive cell through an optical fibre (28).

**6.** Magnetometer according to one of Claims 1 to 6, characterised in that it comprises means (3) associated with the sensitive cell, for producing therein a high-frequency soft electrical discharge, capable of creating metastable helium atoms, and in that the narrow-band tunable laser (2) is tuned onto a line of a spectral transition from this metastable state.

**7.** Magnetometer according to Claim 6, characterised in that the metastable helium atoms are those of the $2^3S$ level and in that the spectral transition is a $2^3P$-$2^3S$ transition.

**8.** Magnetometer according to one of Claims 1 to 7, characterised in that it comprises means for measuring the magnetic induction from the electronic magnetic resonance frequency of helium in the metastable level.

**9.** Magnetometer according to Claim 8, characterised in that the measurement means comprise:
- means (40, 41, 42) for applying to the sensitive cell a variable radio frequency electromagnetic field transverse to the direction of the excitational light, and
- means (44, 45, 46) for determining the radio frequency value for which electronic magnetic resonance of the $2^3S_1$ metastable atoms is produced, from a detection (44) of the light flux transmitted through the sensitive cell.

**10.** Magnetometer according to Claim 9, characterised in that the means for measuring the light flux transmitted operate with synchronous detection (45) with respect to the value of the frequency of the transverse electromagnetic field.

**11.** Magnetometer according to either of Claims 9 and 10, characterised in that the measurement of the transmitted light flux (FT) is performed using another optical fibre (43).

**12.** Magnetometer according to one of Claims 8 to 11, characterised in that the sensitive cell (1) contains natural helium $^4$He.

**13.** Magnetometer according to one of Claims 1 to 7, characterised in that the sensitive cell (1) contains helium isotope $^3$He, and in that it comprises means (7) for measuring the magnetic induction from the nuclear magnetic resonance frequency of the $^3$He atoms.

**14.** Magnetometer according to Claim 13, characterised in that the measurement means comprise:
- a first pair of coils (50) temporarily powered in order to cause a short tilt in the longitudinal nuclear orientation of the $^3$He atoms, and
- a second pair of coils (61, 62) mounted in the immediate vicinity of the sensitive cell in order to pick up the electromotive force induced by the free precession of the nuclear spins of the $^3$He atoms after their forced tilt, the frequency of the signal thus picked up (71, 72) being directly proportional to the value of the magnetic induction existing in the sensitive cell.

**Patentansprüche**

**1.** Helium-Magnetometer von der Art, die
- eine aus einem Behälter gebildete, wenigstens teilweise transparente und Helium enthaltende Meßzelle (1),
- eine auf die Meßzelle gerichtete Quelle (2) von Anregungslicht,
- und Einrichtungen (3) enthält, um im Helium eine Population von metastabilen Atomen zu erzeugen,
- wobei die in der Zelle herrschende magnetische Induktion als Folge der magnetischen Resonanzeigenschaften eines Helium-Energieniveaus meßbar ist,

dadurch gekennzeichnet, daß die Quelle (2) des Anregungslichts ein verstimmbarer Laser schmaler Bandbreite ist, der geeignet ist, selektiv merklich einen und nur einen der Übergänge aus einem metastabilen Zustand des Heliums anzuregen, und der einen Halbleiterlaser (23) als Einrichtung zum primären Pumpen enthält.

**2.** Magnetometer nach Anspruch 1, dadurch gekennzeichnet, daß die Quelle (2) des Anregungslichts einen Laser vom LNA-Typ (Lanthan-Neodym-Aluminat) enthält.

**3.** Magnetometer nach Anspruch 2, dadurch gekennzeichnet, daß der LNA-Laser (2)
- einen Einkristall (20) von LNA, der zwischen zwei reflektierenden Elementen (21, 23) angeordnet ist,
- Einrichtungen zum primären Pumpen (23, 24) dieses Lasers und
- Abstimmeinrichtungen (25) für diesen Laser enthält.

**4.** Magnetometer nach einem der Ansprüche 2 und 3, dadurch gekennzeichnet, daß das Austrittslicht (FP) des LNA-Lasers durch einen Zirkularpolarisator (29) zur Meßzelle geschickt wird.

**5.** Magnetometer nach einem der Ansprüche 1 bis 4, dadurch gekennzeichnet, daß das Laserlicht (FP) über eine Fiberoptik (28) zur Meßzelle geleitet wird.

**6.** Magnetometer nach einem der Ansprüche 1 bis 5, dadurch gekennzeichnet, daß es der Meßzelle zugeordnete Einrichtungen (3) enthält, um dort eine stille elektrische Entladung bei hoher Frequenz hervorzurufen, geeignet, metastabile Heliumatome zu erzeugen, und dadurch, daß der verstimmbare Laser (2) schmaler Bandbreite auf einen Peak eines spektralen Übergangs aus diesem metastabilen Zustand abgestimmt wird.

**7.** Magnetometer nach Anspruch 6, dadurch gekennzeichnet, daß die metastabilen Heliumatome vom Niveau $2^3S$ sind und daß der spektrale Übergang ein Übergang $2^3P$ -> $2^3S$ ist.

**8.** Magnetometer nach einem der Ansprüche 1 bis 7, dadurch gekennzeichnet, daß es Einrichtungen enthält, um die magnetische Induktion ausgehend von der Frequenz der magnetischen Elektronenresonanz von Helium im metastabilen Niveau zu messen.

**9.** Magnetometer nach Anspruch 8, dadurch gekennzeichnet, daß die Meßeinrichtungen
- Einrichtungen (40, 41, 42), um ein elektromagnetisches Feld variabler Radiofrequenz an die Meßzelle anzulegen, transversal zur Richtung des Anregungslichts, und
- Einrichtungen (44, 45, 46) zur Bestimmung des Wertes der Radiofrequenz enthalten, bei der die magnetische Elektronenresonanz der metastabilen Atome $2^3S_1$ stattfindet, ausgehend von einer Detektion (44) des durch die Meßzelle gelassenen Lichtstroms.

**10.** Magnetometer nach Anspruch 9, dadurch gekennzeichnet, daß die Einrichtungen zur Messung des durchgelassenen Lichtstroms mit Synchrondetektion (45) hinsichtlich des Wertes der Frequenz des transversalen elektromagnetischen Feldes arbeiten.

**11.** Magnetometer nach einem der Ansprüche 9 und 10, dadurch gekennzeichnet, daß die Messung des duchgelassenen Lichtstroms (FT) mit Hilfe einer weiteren Fiberoptik (43) durchgeführt wird.

**12.** Magnetometer nach einem der Ansprüche 8 bis 11, dadurch gekennzeichnet, daß die Meßzelle (1) natürliches Helium $^4He$ enthält.

**13.** Magnetometer nach einem der Ansprüche 1 bis 7, dadurch gekennzeichnet, daß die Meßzelle (1) isotopisches Helium $^3He$ enthält und daß es Einrichtungen (7) enthält, um die magnetische Induktion ausgehend von der Frequenz der kernmagnetischen Resonanz der $^3He$-Atome zu messen.

**14.** Magnetometer nach Anspruch 13, dadurch gekennzeichnet, daß die Meßeinrichtungen
- ein erstes Paar Spulen (50), die zeitweise gespeist werden, um eine kurzes Umkippen der longitudinalen Kernorientierung der $^3He$-Atome zu bewirken, und
- ein zweites Paar Spulen (61, 62) enthalten, die in unmittelbarer Nachbarschaft der Meßzelle angebracht sind, um die durch die freie Präzession der Kernspins der $^3He$-Atome nach ihrem erzwungenen Umkippen induzierte elektromotorische Kraft aufzufangen, wobei die Frequenz des so aufgefangenen Signals (71, 72) direkt proportional ist zum Wert der in der Meßzelle herrschenden magnetischen Induktion.

FIG.1

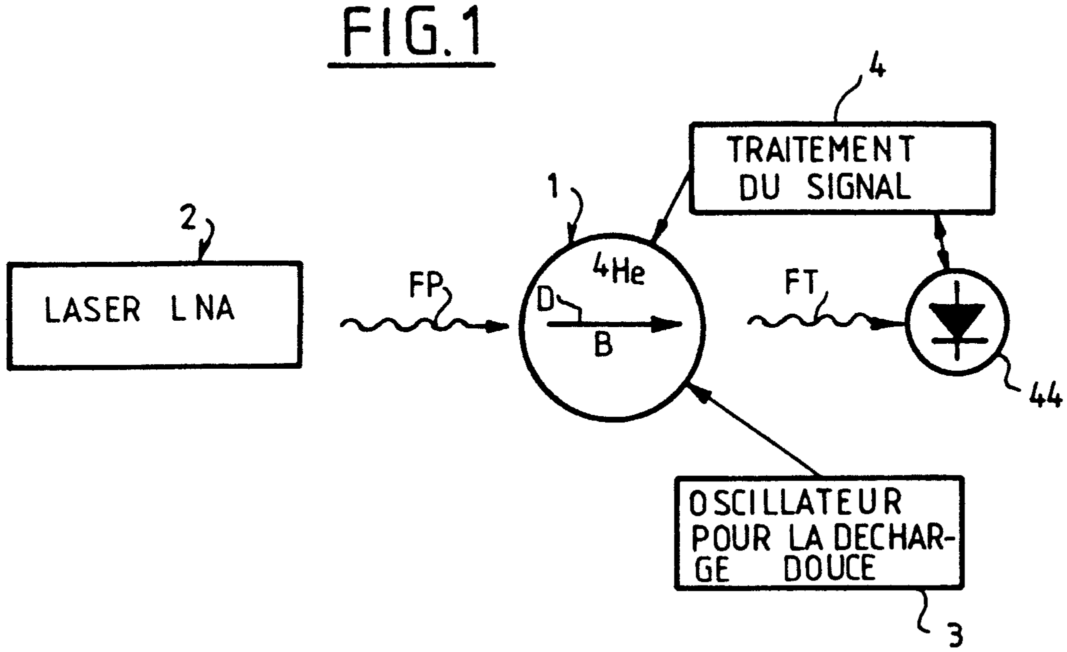
4
TRAITEMENT DU SIGNAL
1
2
LASER LNA
FP
4He
D
B
FT
44
OSCILLATEUR POUR LA DECHAR-GE DOUCE
3

FIG. 4

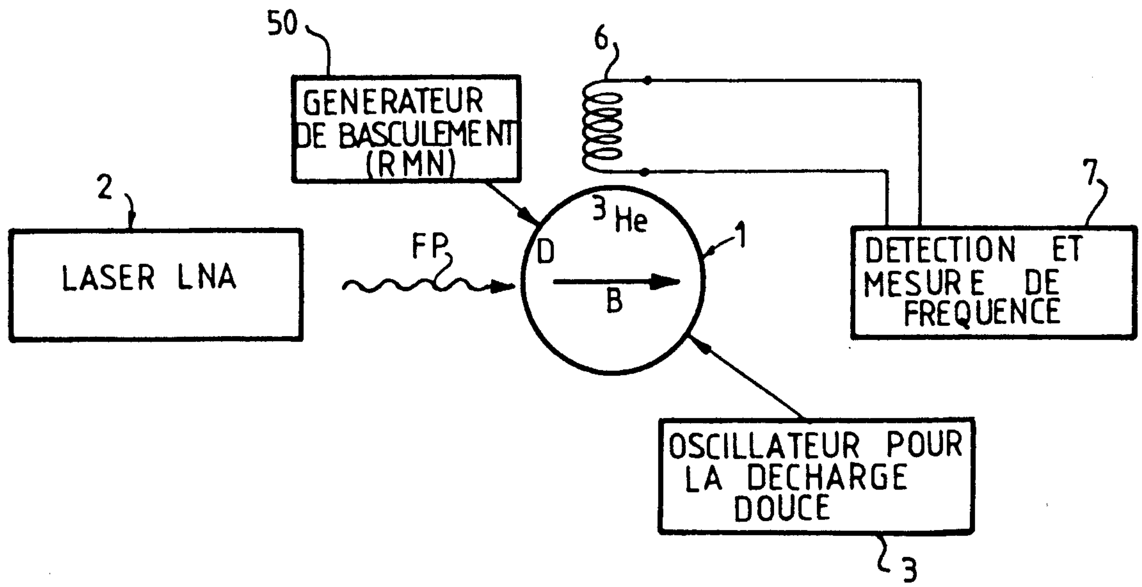
50
GENERATEUR DE BASCULEMENT (RMN)
6
2
LASER LNA
FP
3 He
D
B
1
7
DETECTION ET MESURE DE FREQUENCE
OSCILLATEUR POUR LA DECHARGE DOUCE
3

FIG. 2

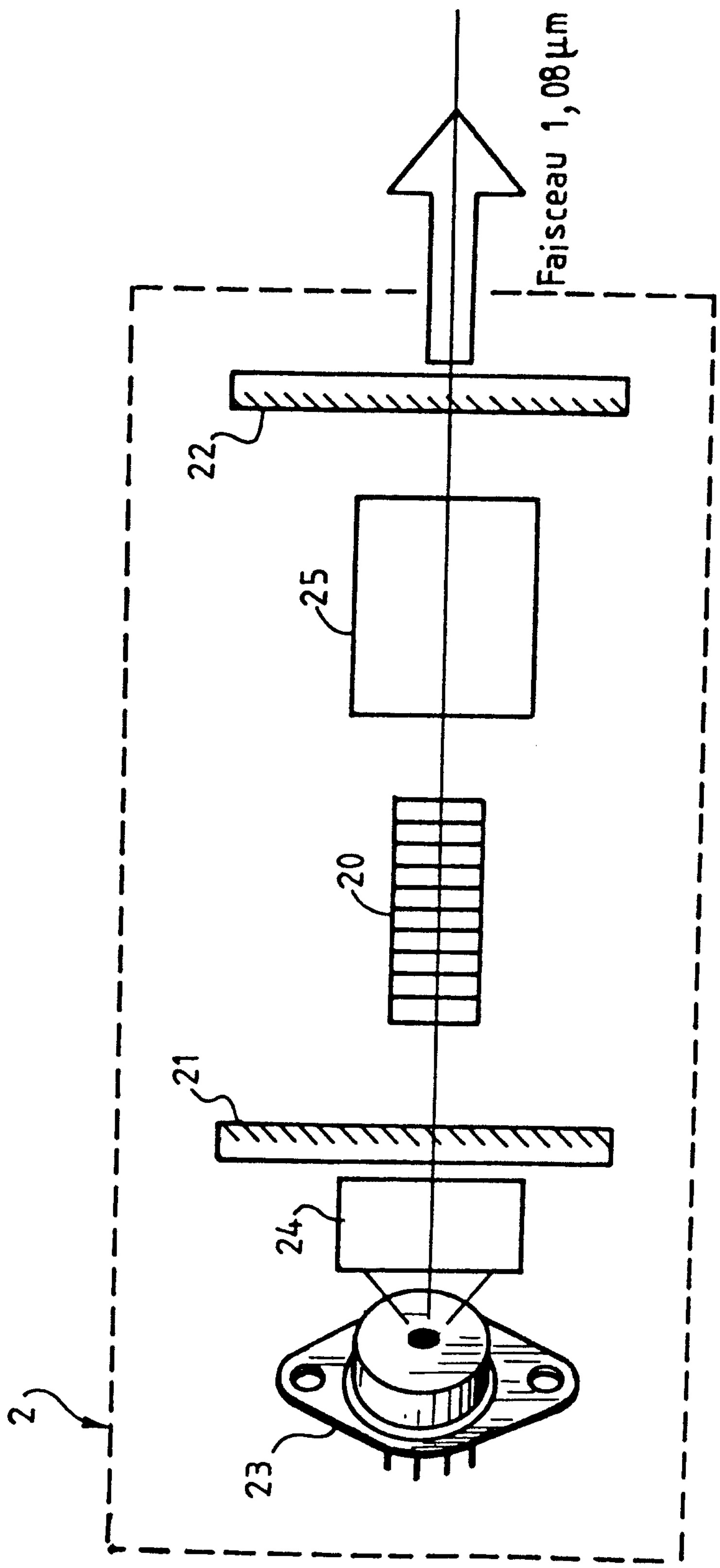

FIG. 3

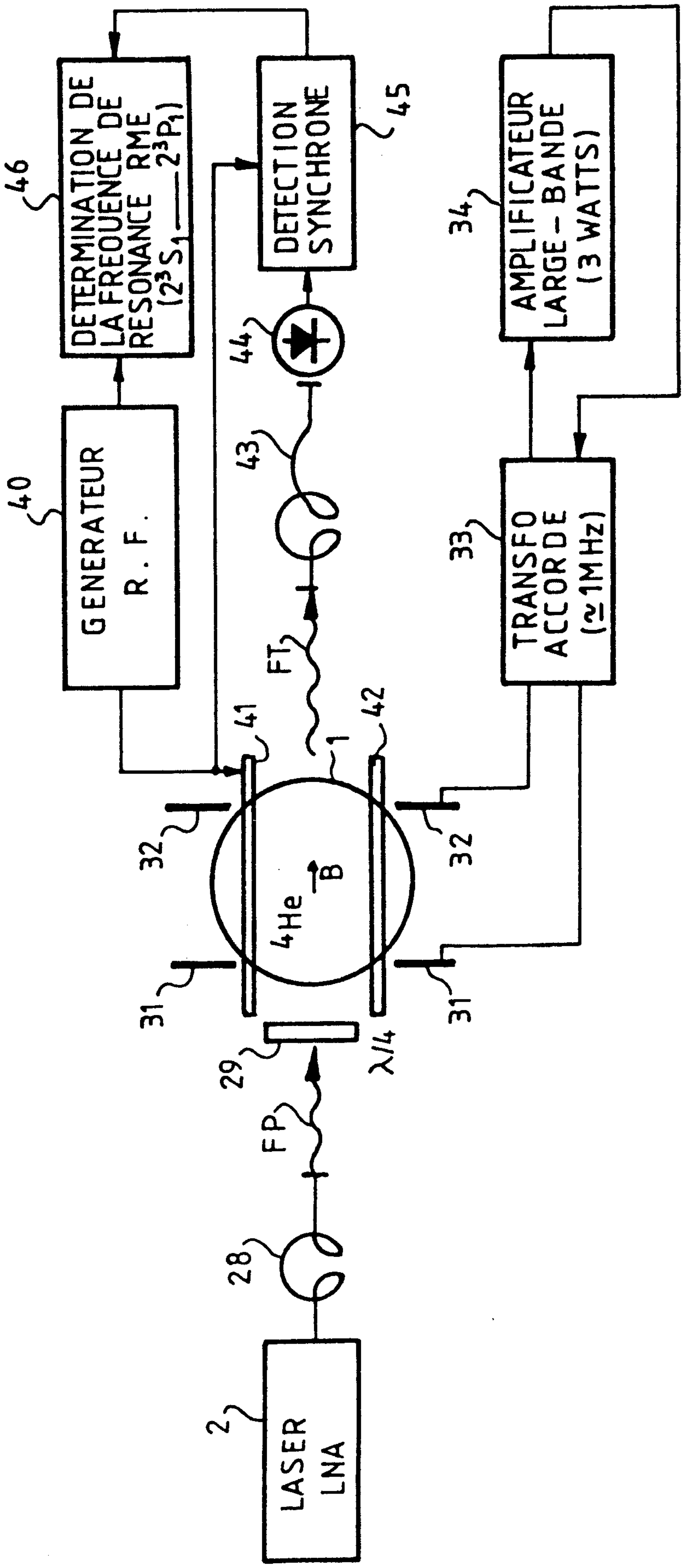
LASER
LNA
2
28
FP
29
λ/4
31
32
$^4$He
B
1
41
42
FT
43
44
GENERATEUR
R. F.
40
DETERMINATION DE
LA FREQUENCE DE
RESONANCE RME
(2$^3$S$_1$ —— 2$^3$P$_1$)
46
DETECTION
SYNCHRONE
45
TRANSFO
ACCORDE
(≃1MHz)
33
AMPLIFICATEUR
LARGE – BANDE
(3 WATTS)
34

FIG.5

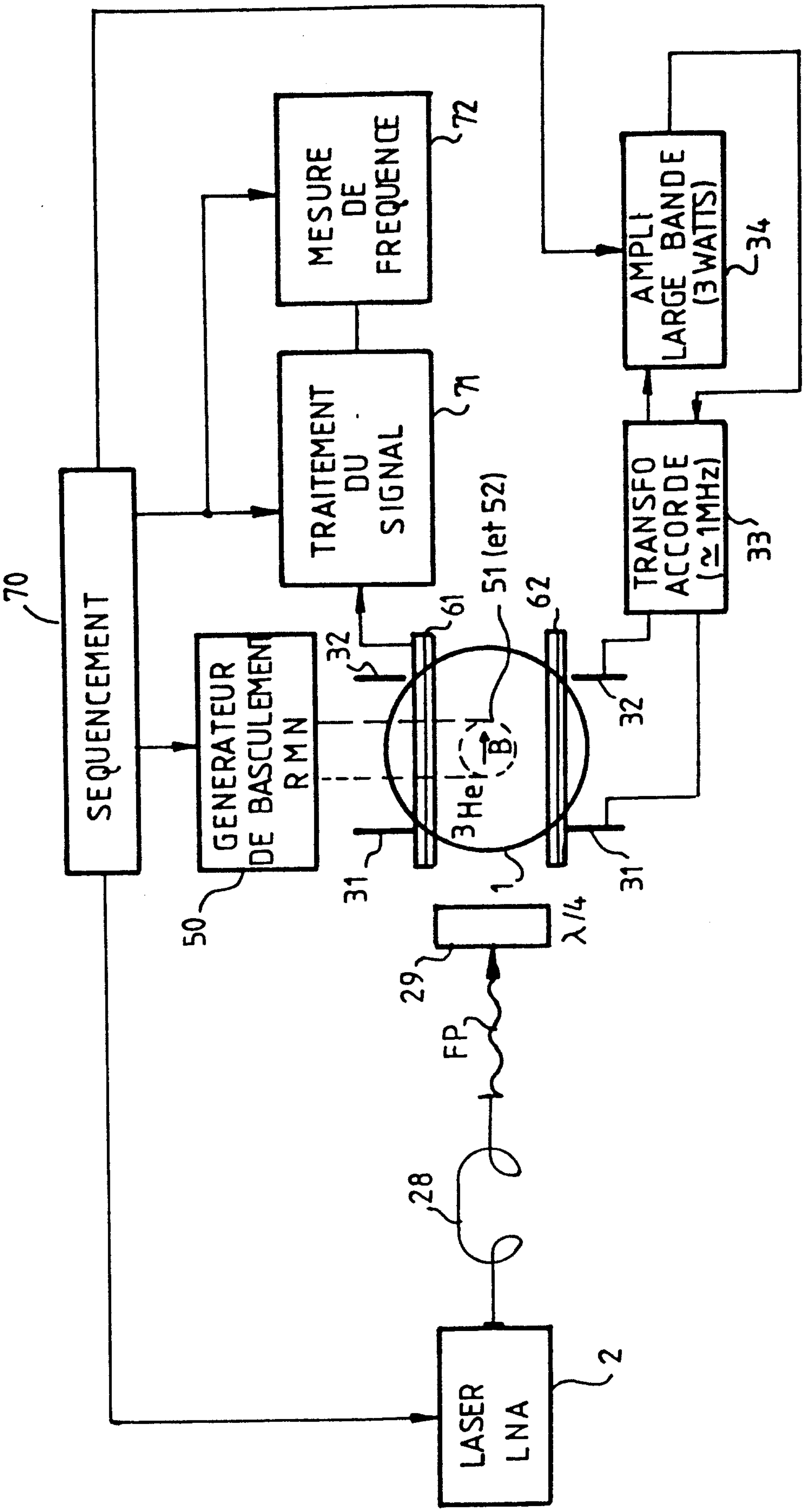
SEQUENCEMENT
70
GENERATEUR DE BASCULEMENT RMN
50
TRAITEMENT DU SIGNAL
71
MESURE DE FREQUENCE
72
TRANSFO ACCORDE (≃1MHz)
33
AMPLI LARGE BANDE (3 WATTS)
34
LASER LNA
2
28
FP
29
λ/4
1
31
32
61
62
51 (et 52)
3He
B

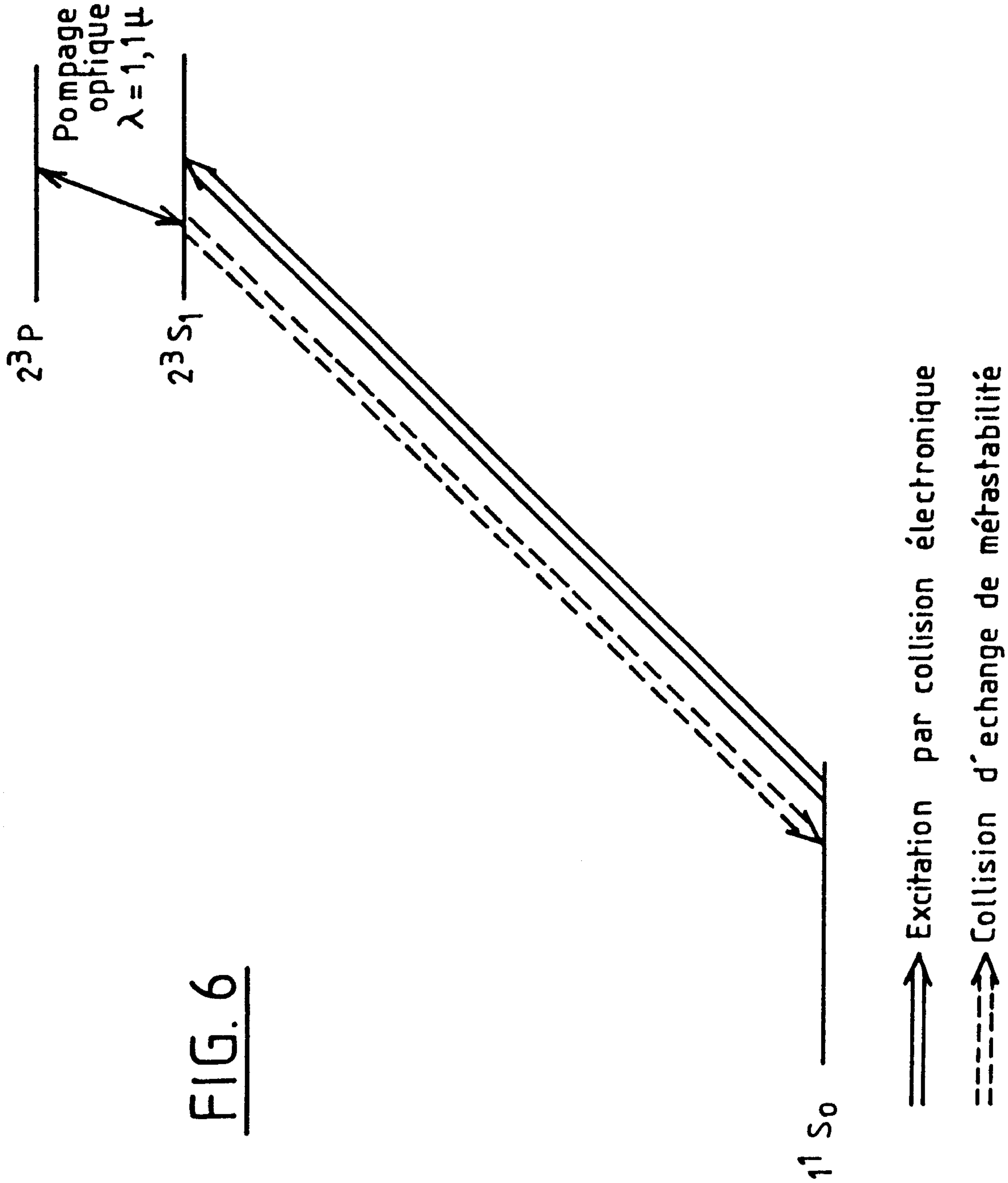

$2^3P$
$2^3S_1$
$1^1S_0$
Pompage optique $\lambda = 1,1\mu$
Excitation par collision électronique
Collision d'echange de métastabilité


FIG. 6